# EUROPEAN PATENT APPLICATION

(11) **EP 1 755 168 A2**
(43) Date of publication of application: **21.02.2007**
(21) Application number: 06016715.2
(22) Date of filing: 10.08.2006
(51) Int. Cl.: H01L 29/732, H01L 29/739, H01L 21/331

(54) **Deep N diffusion for trench IGBT**

(30) Priority: 15.08.2005 US 204074
(71) Applicant: INTERNATIONAL RECTIFIER CORPORATION, El Segundo, CA 90245 (US)
(72) Inventor: Francis, Richard, Manhattan Beach California 90266 (US); NG, Chiu, El Segundo California 90245 (US)
(74) Representative: Maiwald Patentanwalts GmbH

(57) **Abstract**

An increased conductivity deep diffusion of the same conductivity type as that of the drift region is provided between adjacent trenches of a trench type IGBT and below the trenches to reduce the on resistance components of the drift region resistance and spreading resistance to current flow when the device is turned on. The deep diffusion has a higher concentration than that of the drift region, and has a width of from 4 to 10 microns. The wafer or die has a total width (or thickness) of about 70 to about 300 microns.

## Description

### FIELD OF THE INVENTION

This invention relates to trench type Insulated Gate Bipolar Transistors (IGBTs) and more specifically relates to such IGBTs with a reduced forward voltage drop.

### BACKGROUND OF THE INVENTION

IGBTs are well known and are frequently implemented with a planar cellular or stripe topology. These devices have an inherent JFET which increases the device on-resistance R_{DSON} and, thus the forward voltage drop V_{CE(ON)}. Further, such devices have an inherent four layer parasitic thyristor structure which will latch on if the NPN transistor of the thyristor turns on.

It is known that IGBTs can be made with a trench topology which eliminates the inherent JFET of the planar device. However, trench IGBTs still have the inherent four layer structure whereby, if the inherent NPN transistor in the four layer device turns on (if the current through R_{B}, is sufficiently high), the device will latch on. It is also desirable to reduce the saturation current of the device without increasing the value of R_{B}.

It has further been found that trench IGBTs tend to be "fragile", that is, they can fail particularly when switching an inductive load. This is sometimes termed a low safe operating area (SOA) under reverse bias. This problem again is aggravated by an increased R_{B'}.

U.S. Patent 6,683,331 the disclosure of which is incorporated herein by reference, describes a trench IGBT structure and process for its manufacture, creating a non-punch through (NPT) IGBT having a reduced R_{B'}, a reduced saturation current, a low threshold voltage V_{T} and an enlarged SOA. More specifically, a structure is .provided having a deep emitter diffusion which is very narrow (of small lateral extent) to reduce R_{B'}. Further, a very deep P channel diffusion is employed between spaced trenches to create a very long inversion channel. Thus, when the device goes into avalanche, the path for hole current under the emitter has a reduced lateral extent, reducing R_{B}, and the trench is very deep (about 8 microns) so that the P region adjacent the channel can support reasonable voltage and the N- body concentration and depth can be optimized. The increased depth of the emitter along the trench controls threshold voltage since it permits the use of a very deep P⁺ region without the danger of its encroaching into the channel (which would increase V_{T}). Finally, a helium implant may be employed for lifetime killing in only the P well.

Further, the device of the 6,683,331 patent may be built in float zone silicon and no epitaxial layer is needed, with a weak anode structure being employed as in copending application Serial No. 09/565,922, filed May 5, 2000 in the names of Richard Francis and Chiu Ng now U.S. patent 6,482,681.

In the trench IGBT structure disclosed in US6,683,331 the current during forward conduction can be seen as a combination of MOSFET and bipolar currents. The specific on-resistance to the MOSFET current is determined by several components. In 300 - 1200V devices, due to the relatively high resistivity of the drift layer (typically 14-60 Ohm-cm) the major contribution of on resistance is from drift region resistance and spreading resistance below the channel region.

It would be very desirable to provide a device with the advantages of the device of patent 6,683,331, but with a reduced on-resistance.

### BRIEF DESCRIPTION OF THE INVENTION

In accordance with the invention, the spreading and drift region resistance in a trench type IGBT is reduced by the introduction of a deep diffusion layer below the base diffusion. This deep diffusion or "Deep Enhancement", has an opposite doping concentration with respect to the P type base (or N type for an N channel device). The present invention reduces the device forward voltage drop by reducing on resistance. Further the invention provides the possibility to optimize the device to specific applications (e.g. switching frequency). Further, with the invention, in an high lifetime, epitaxial type trench IGBT, the irradiation dose can be increased to reduce the turn-off current and the switching time, hence reducing switching losses for the same forward drop. This is very useful in many applications, and significantly, in a low lifetime, depletion stop type trench IGBT, the deep enhancement of the invention will substantially reduce the device forward drop.

### BRIEF DESCRIPTION OF THE DRAWINGS

Figure 1 is a cross-section through two adjacent trenches of an IGBT trench die having the junction pattern of the device of patent 6,683,331.

Figure 2 is a cross-section like that of Figure 1, but showing the added novel deep enhancement of the invention.

Figure 3 shows a small portion of a wafer (or die) in cross-section, showing a first step in the process to produce the device of Figure 2.

Figure 4 shows the structure of Figure 3 after a mask and implant step.

Figure 5 shows the structure of Figure 4 after a diffusion drive to form an N diffusion.

Figure 6 shows the structure of Figure 5 after a termination mask step and termination implant.

Figure 7 shows the structure of Figure 6 after a boron drive and oxidation step.

Figure 8 shows the structure of Figure 7 after a trench mask and emitter implant.

Figure 9 shows the structure of Figure 8 after an emitter drive and trench etch.

Figure 10 shows the structure of Figure 9 after the completion of the trench cell such as that in Figure 2.

### DETAILED DESCRIPTION OF THE DRAWINGS

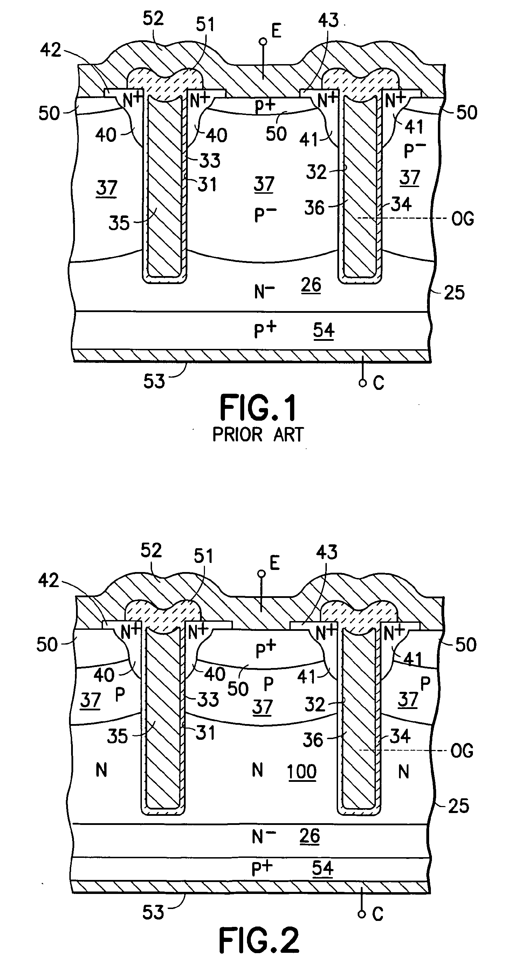

Referring first to Figure 1 there is shown, in cross-section a pair of adjacent cells of the prior art structure of Patent 6,683,331.

The detail of manufacture of the device of Figure 1 is disclosed in patent 6,683,331, including the materials used and process detail such as the reduction of the wafer thickness and the formation of the life time killing used and the collector backside implant 54 and the like.

The structure of Figure 1 is formed in a common starting wafer 25 of float zone material. However, an epitaxial wafer can also be used. The wafer 25 has an N⁻ body which receives adjacent deep trenches 31 and 32 which are lined with thin (for example 1000Å) silicon dioxide gate insulation layers 33, 34 respectively and are filled with conductive polysilicon gates 35 and 36 respectively which are interconnected (not shown and have an external gate terminal G, schematically shown. Trenches 31 and 32 may be about 1.5 microns wide, spaced by about 5 to 10 microns and may have a depth of 4 to 9 microns, and preferably about 6.5 microns. These extend through a P- base diffusion 37 which, at the trench region, is about 5 microns deep (as measured from the top surface of the silicon) for an 8 micron deep trench.

Trenches 31 and 32 extend through N⁺ emitter regions 40 and 41 respectively which are very deep (2 microns to 4 microns) and have a very short lateral extension, for example 1.5 microns to 3 microns. Note that emitter regions 40 and 41 have shallow shelf contact regions 42 and 43 respectively, which have a lateral extension of about 0.2 microns to 0.5 microns.

Significantly, trenches 31 and 32 extend into the deep enhancement region 100 for about 2µm (non-critical).

A P⁺ contact region 50 extends into P⁻ base 37 and between emitter regions 40 and 41. The polysilicon gates 35 and 36 are covered by a suitable insulation oxide 51 and the top surface of the device receives an aluminum or other suitable emitter contact 52. The backside of the device contains a P⁺ diffusion 54 which receives collector contact 53.

The use of the very deep trench (6.5 microns) and very deep P⁻ base 37 (7 microns) permits the use of the very deep, but narrow emitter regions 40 and 41 while still leaving a sufficiently long invertible channel below the emitter regions (for example, 2 microns) to permit the P regions 37 to support a reasonable voltage and so that the N⁻ body 26 can be optimized. Further, when the device operates in avalanche, a hole current flows from P⁺ region 54 and up and under the emitters 40 and 41 and through the effective resistance R_{B}, under the emitter regions 40 and 41. This resistance is very low to avoid the turn on of the NPN transistor 40, 37, 26, for example, and to avoid latching on the IGBT structure.

Note that the ledge regions 43, 43 of emitters 40 and 41 respectively are atop the P⁺ regions 50 and do not form a part of the R_{B}, of the device. These ledges 42, 43, however are major points for connection of the emitter regions 40 and 41 to emitter contact and permit such connection even with unavoidable mask misalignment during manufacture..

The present invention is an improvement of the structure of Figure 1 and is shown in Figure 2, where components similar to those of Figure 1 are given the same identifying numerals. The basic difference in Figure 2 is the use of the novel deep enhancement N region 100 which is disposed between the bottoms of trenches 31 and 32 and beneath the trenches. The N region 100 would be a P region in a P channel device with all other concentration types reversed.

The deep enhancement 100 may have a depth of 4µm to 10µm (with a 6µm deep trench) and has a concentration substantially greater than that of N⁻ body 26. This deep enhancement 100 reduces the spreading and drift region resistance of the device, thereby to reduce the forward voltage drop of the device. Further, the region 100 can be adjusted in concentration and depth to optimize the device to a specific application. For example, switching frequency can be preferred over other parameters for a particular application. In a high lifetime epitaxial device, the irradiation dose can be increased to reduce turn-off current at the switching time to reduce switching losses for the same forward voltage drop. Further, in a low lifetime depletion stop type trench IGBT, the deep enhancement region 100 will substantially reduce the forward voltage drop.

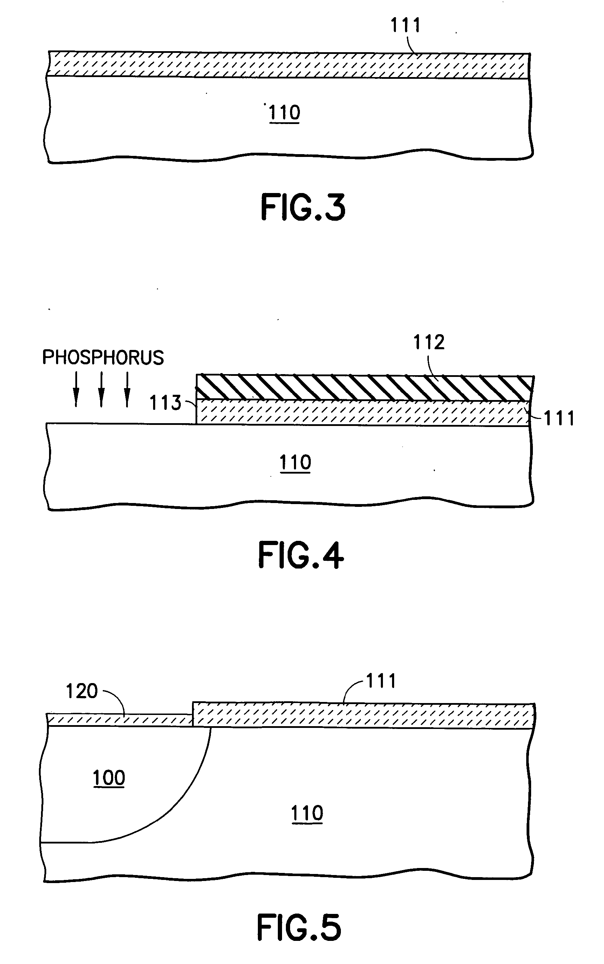

Figures 3 to 9 show a process sequence which can be used to make the device of Figure 2. The doses and implant densities described are for a particular device and can be altered as desired while still practicing the present invention. Thus, in Figure 3 a starting wafer 110 of silicon having a resistivity of 22 to 30 ohm-cm has an oxide layer 111 grown thereon to a thickness of 1µm.

Figure 4 shows a mask step in which a photoresist 112 is processed to open a window 113 in oxide layer 111. A phosphorus implant of dose between 1E12 to 1E13/cm² at 120 KeV is then applied to the exposed silicon surface in Figure 4.

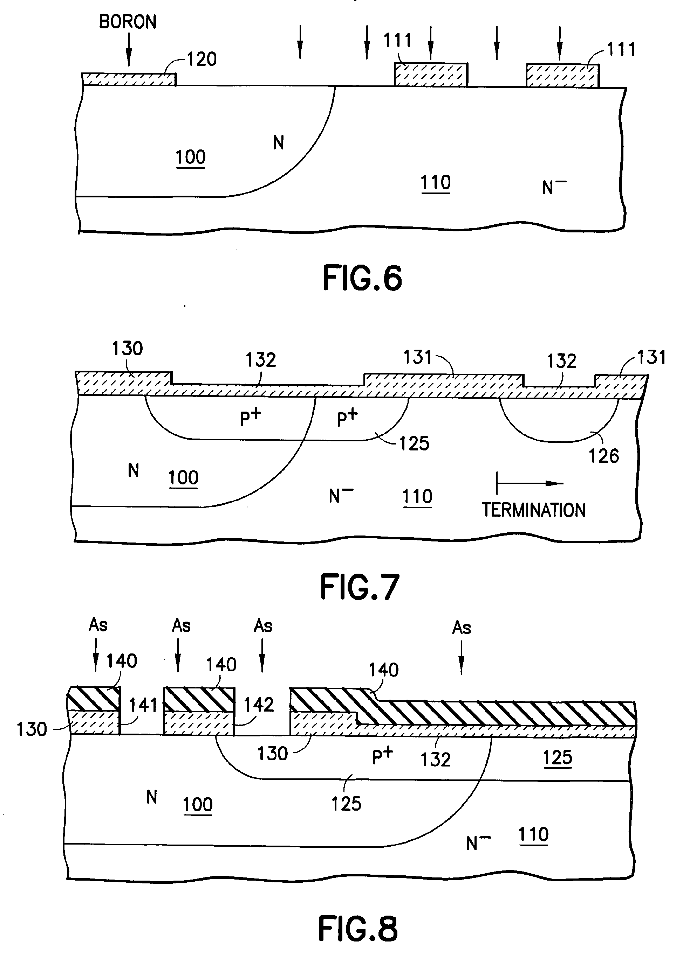

The photoresist 112 is then stripped and the phosphorus implant is driven for 4 to 16 hours at 1175°C to drive the novel deep N diffusion 100. At the same time, oxide 111 grows to about 1.2µm and thinner oxide layer 120 grows to about 7000Å as shown in Figure 5. Region 100 will deepen with each subsequent thermal treatment..

A termination mask step is then carried out and, as shown in Figure 6, the termination mask defines windows in oxide layers 111 and 120 and the wafer is exposed to a boron implant at a dose of 7E14/cm². This implant is then driven for 2 hours at 1175°C as shown in Figure 7, forming the P⁺ channel region 125 and termination diffusion 126. At the same time new oxide is grown, including thickened regions 130 (9000Å), 131 (1.4µm) and 132 (7000Å).

Figure 8 shows the next step in which a trench mask 140 is provided which also acts as an emitter implant mask. Thus, windows 141 and 142 are opened in oxide 130, 132 and an arsenic implant is carried out at 1E16/cm² at 120 KeV. The implant is then driven for 30 minutes at 1175°C, forming N⁺⁺ emitter regions 150.

Thereafter, as shown in Figure 8 a trench etch is carried out, forming spaced parallel trenches 160, 161 having a depth of about 6µm.

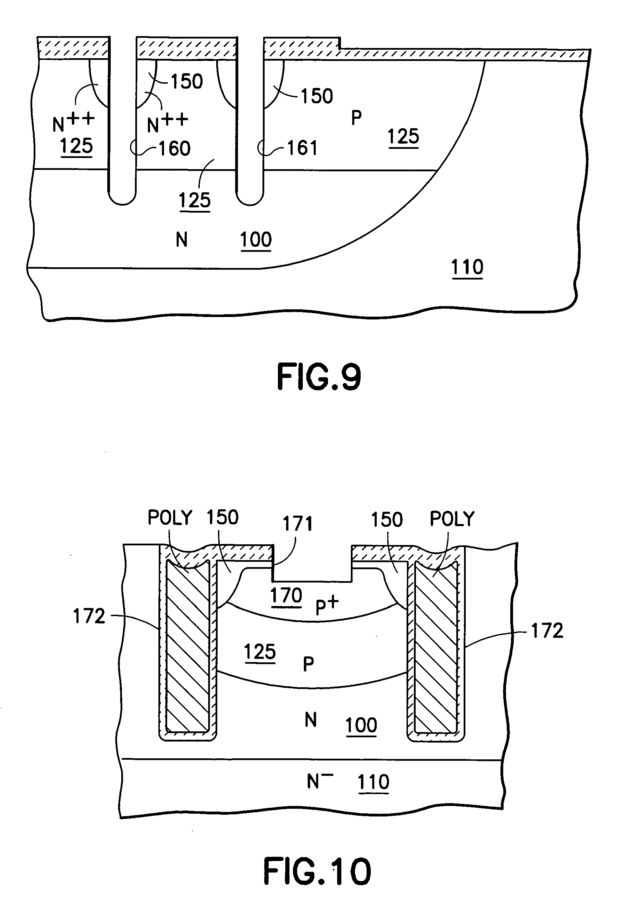

The cell structure is then completed as shown in U.S. Patent 6,683,331 and as shown in Figure 9. Note that the P⁺ region 170 is implanted and diffused through contact window 171 which is about 3µm wide. The gate oxide 172 is about 1500Å thick and the trench spacing is about 6µm. The trench widths are about 1.5 microns.

In the process described, the cells described are two of up to many thousands in a single die, and are formed with the die in the wafer stage. The terms die and wafer may herein be used interchangeably.

Although the present invention has been described in relation to particular embodiments thereof, many other variations and modifications and other uses will become apparent to those skilled in the art. It is preferred, therefore, that the present invention be limited not by the specific disclosure herein.
An increased conductivity deep diffusion of the same conductivity type as that of the drift region is provided between adjacent trenches of a trench type IGBT and below the trenches to reduce the on resistance components of the drift region resistance and spreading resistance to current flow when the device is turned on. The deep diffusion has a higher concentration than that of the drift region, and has a width of from 4 to 10 microns. The wafer or die has a total width (or thickness) of about 70 to about 300 microns.

## Claims

1. A trench IGBT having a deep diffusion for reducing its forward voltage drop, comprising a body of monocrystaline silicon of one of the conductivity types and having a first concentration, and having a parallel top and bottom surfaces; a plurality of spaced trenches extending perpendicularly into said top surface for a given depth; a gate insulation layer lining the vertical walls of said trenches; a channel diffusion of the other conductivity type formed between each of said trenches and having a depth which is less than the depth of said trenches; an emitter diffusion of said one of the conductivity types extending from said top surface of said body and along an upper portion of each of said trenches; said emitter diffusions being spaced from one another by a given distance between said trenches; a shallow contact diffusion of said other conductivity type which has a high concentration compared to that of said channel diffusion and disposed between adjacent pairs of said emitter diffusions; a collector diffusion of said other conductivity type in said bottom surface; an emitter metal electrode in contact with said emitter and channel diffusions and a collector electrode in contact with said collector diffusion; and a deep diffusion of said one conductivity type and having a conductivity greater than that of said first conductivity disposed beneath said channel diffusion and extending to beneath the bottom of said trenches.

2. The device of claim 1, wherein said trenches have a depth of from 4 to 9 microns and are spaced by about 5 to 10 microns and have a width of about 1.5 microns.

3. The device of claim 1, wherein said trenches have a depth of about 6 microns and wherein said trenches are deeper than said channel diffusion and said deep diffusion has a width of 4 to 10 microns.

4. The device of claim 1, wherein the top surface of said emitter regions each have further high concentration shallow contact diffusions of said other of the conductivity types.

5. The device of claim 2, wherein the top surface of said emitter regions each have further high concentration shallow contact diffusions of said other of the conductivity types.

6. The device of claim 3, wherein the top surface of said emitter regions each have further high concentration shallow contact diffusions of said other of the conductivity types.

7. The device of claim 1, wherein said emitter regions have a depth of 2 to 4 microns and a lateral width of 1.5 to 3 microns, and wherein said depth is greater than said width.

8. The device of claim 1, wherein said emitter regions have shallow lateral extensions facing further away from their respective trenches to provide an increased contact surface to contact said emitter metal.

9. The device of claim 8, wherein the top surface of said emitter regions each have further high concentration shallow diffusions of said other of the conductivity types.

10. The device of claim 9, wherein said trenches have a depth of from 4 to 9 microns and are spaced by about 5 to 10 microns and have a width of about 1.5 microns.

11. The device of claim 1, wherein said one conductivity type is N.

12. The device of claim 1, wherein said trenches are laterally spaced straight parallel trenches.

13. The device of claim 1, wherein said trenches are multi-sided polygons in cross-section through the depth of said trenches.

14. The device of claim 1, which includes a further diffusion of a first conductivity type into said channel region and having a higher concentration than that of said channel region; said further diffusion extending under said lateral extensions of said emitter regions and making contact to said emitter metal.
